(19) Europäisches Patentamt
European Patent Office
Office européen des brevets

(11) **EP 2 897 291 A1**

(12) **EUROPEAN PATENT APPLICATION**

(43) Date of publication:
**22.07.2015 Bulletin 2015/30**

(51) Int Cl.:
***H03J 3/18*** (2006.01)

(21) Application number: **15151849.5**

(22) Date of filing: **20.01.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **20.01.2014 TR 201400622**

(71) Applicants:
• **Istanbul Universitesi Rektorlugu**
  **34452 Istanbul (TR)**
• **Yarman, Bekir Siddik Binboga**
  **34320 Istanbul (TR)**
• **Atilla, Dogu Cagdas**
  **34320 Istanbul (TR)**

• **Aydin, Cagatay**
  **34320 Istanbul (TR)**

(72) Inventors:
• **Yarman, Bekir Siddik Binboga**
  **34320 Istanbul (TR)**
• **Atilla, Dogu Cagdas**
  **34320 Istanbul (TR)**
• **Aydin, Cagatay**
  **34320 Istanbul (TR)**

(74) Representative: **Mutlu, Aydin et al**
  **Invokat Intellectual Property Services**
  **Agaoglu My Office 212-D:241**
  **Basin Ekspres Yolu Tasocagi**
  **Cad. No: 3 Bagcilar**
  **34218 Istanbul (TR)**

(54) **Adjustable inductor**

(57)    The present invention relates to an adjustable inductor structure which would be used for improvement in gain and reflection parameters in broadband harmonization and amplifier circuits which are one of the pillar elements of the communication systems working in radio frequencies. Said inductor structure comprises a constant inductor and a voltage-adjustable capacitor connected to said constant inductor in parallel.

**Fig. 7**

Printed by Jouve, 75001 PARIS (FR)

**Description**

**Technical Field of the Invention**

The present invention relates generally to circuit elements used for improving gain and reflection parameters in broadband harmonization and amplifier circuits used in communication systems. The invention particularly relates to an inductor circuit element which can be adjusted according to the frequency at a desired operating frequency and to the use of the same in software-based wireless communication technologies working in GSM-900, GSM-1800, 3G/4G, Wi-Fi, LTE/Wi-Max standards.

**Background of the Invention**

The studies upon broadband systems increase because of the requirement of operating in different frequencies as a result of the improvements experienced in wireless communication technologies in recent years. It is inevitable to use broadband antennas and power transfer circuit in wireless communication systems having many standards such as GSM-900MHz and GSM-1800MHz, 3G/4G, Wi-Fi, LTE/Wi-Max. Having an adjustable amplifier and an adjustable filter improves gain and reflection parameters of this power transfer. Thus, limits of the costs and designs of the device would not be urged.

For these reasons, it is also inevitable that the values of the elements in impedance harmonization circuits are adjustable. Fundamentally, harmonization circuits are formed by connecting simple passive inductors and capacitors in series and in parallel. Adjustable capacitors are verified by using varactors. However, it is almost impossible to adjust inductors without using a switch.

An adjustable inductor embodiment is also disclosed in US 2008/0180194 A1. The adjustable inductor assembly disclosed in this document is used in a center frequency adjusting device to increase and decrease the center frequency value with a cut-off capacitor without increasing the circuit assembly or without decreasing Q factor which affects the circuit performance. Similarly, frequency control of an electromagnetic inductor disclosed in US 2004/0217882 A1 is also done manually. However, said inductor is out of the scope of the present invention because it is used generally in detector circuits.

In this regard, it is an inevitable situation that circuit elements of impedance harmonization and amplifier circuits, which are one of the pillar elements of software defined radio communication systems gained importance in recent years, should be adjustable. The adjustable inductor of the invention has the capability to provide adjustability of impedance harmonization circuits and amplifiers in wireless communication systems which comprise many standards on itself such as GSM-900MHz and GSM-1800MHz, 3G/4G, Wi-Fi, LTE/Wi-Max.

**Brief Description of the Invention**

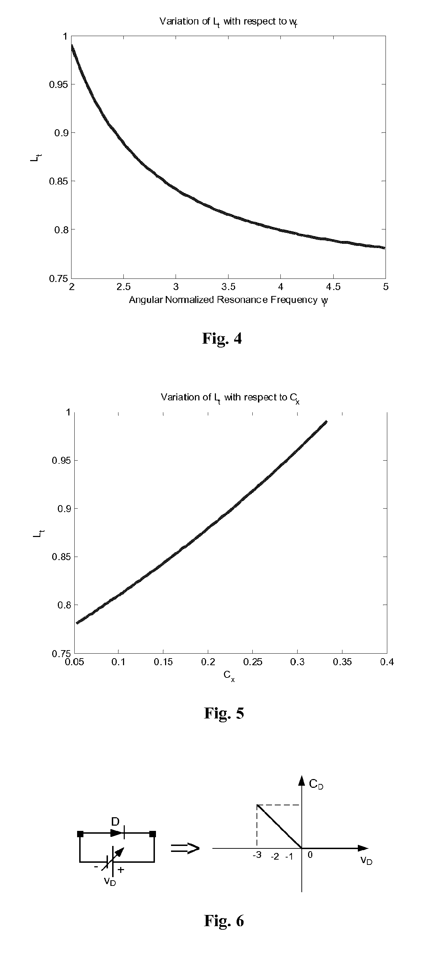

The present invention provides a frequency-based adjustable inductor (Lt) structure to solve the technical problems mentioned above. A voltage-adjustable capacitor ($C_x$) connected to a constant inductor ($L_x$) in parallel is presented in this inductor (Lt) structure (Figure 6). Thus, this constant inductor (Lt) is made adjustable by changing the voltage value of the adjustable capacity.

The frequency-based adjustable inductor (Lt) presented with said circuit arrangement has the ability to be used in broadband harmonization and amplifier circuits of wireless communication systems in the standard of GSM -900MHz, GSM-1800MHz, 3G/4G, Wi-Fi, LTE/Wi-Max. It is shown in Figure 1 that $Z_x(j\omega) = jX_x(\omega)$ impedance and $Z(j\omega) = j\omega L = jX(\omega)$ inductive impedance of the parallel resonance $C_x$ // $L_x$ circuit connected to an electric/electronic circuit in series can be adjusted almost equivalent to each other. It is also seen in Figure 2 that absolute error within the range of $0 \leq \omega \leq 1$ band is lower than 0.1. The change graph of the frequency-based adjustable inductor $L_t = f(\omega, L_x, C_x)$ is given in Figure 3. In addition, it may be seen that the frequency-based inductor remains within the range of $L_x$ and $L$. In Figure 4 and Figure 5, the change of $L_t$ according to $\omega_r$ and $C_x$ is shown respectively in the case of $\omega = \omega_0 = 1$ and the adjustability of the frequency-based inductor is quite narrow. It is seen that when the value of the adjustable capacitor is increased from $C_x = 0.1$ to $C_x = 0.3$, the effective value of $L_t$ increases from 0.8 to 0.95. This increase approximately corresponds to %15 change. In practice, the adjustable capacitor $C_x$ can be verified by using a varactor diode. The use graphic of varactor diode D as a capacitor is shown in Figure 6. In Figure 7, the diode **D** would show a $\boldsymbol{C_D}$ capacity in the case of its reverse polarization. In this case, $C_0$ capacity with the constant value and $C_D$ capacity with the changing value according to the reverse polarity voltage $\boldsymbol{V_D}$ would be an equivalent $C_x$ capacity. The value of the adjustable capacity connected to a constant inductor in parallel is changed to ensure the adjustability of the adjustable inductor considered as a parallel resonance circuit. By this means, the inductance of the serial resonance circuit is made adjustable.

Brief Description of the Figures

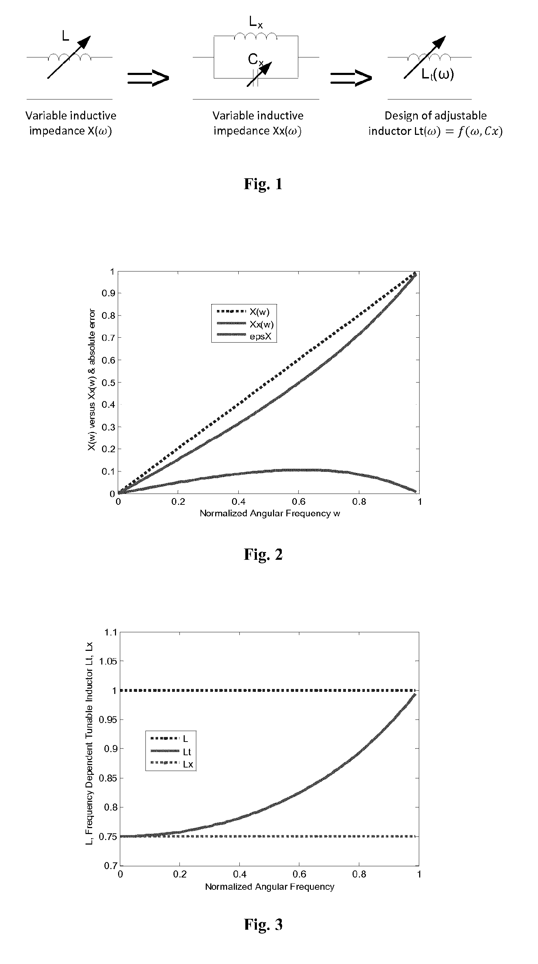

Figure 1 is a representative presentation of serially connected adjustable inductive impedance equivalent of the adjustable inductor of the invention.

Figure 2 is a graph showing the comparison of ideal inductive impedance $X(\omega) = \omega L$ and the equivalent impedance $X_x(\omega)$.

Figure 3 is a graph showing the frequency-based changes of the adjustable inductor $L_t(\omega) = f(\omega, L_x, C_x)$.

Figure 4 is a graph showing the adjustability of $L_t$ according to the resonance frequency $\omega_r$.

Figure 5 is a graph showing the adjustability of $L_t$ according to $C_x$.

Figure 6 is a graphical drawing showing the varactor diode working principle: $C_D = f(V_D)$.

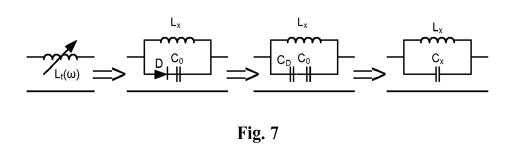

Figure 7 is a representative drawing showing the serial inductor $L_t(\omega)$ structure whose value is adjustable depending on the frequency.

**Detailed Description of the Invention**

In the scope of the invention, it is shown in the form seen in Figure 1 that $Z_x(j\omega) = jX_x(\omega)$ impedance and $Z(j\omega) = j\omega L = jX(\omega)$ inductive impedance of the parallel resonance $C_x // L_x$ circuit connected to an electric/electronic circuit in series can be adjusted almost equivalent to each other. In this regard, given $L$ as an ideal adjustable inductor can be provided by means of an adjustable $C_x$ capacitor and a constant $L_x$ inductor connected thereto in parallel. Thus, this structure acts as a frequency-based adjustable inductor $L_t(\omega)$ at $0 \leq \omega \leq \omega_0 = 1$ normalized angular frequency band. In this study, act of $L_t(\omega)$ can be calculated as a function of normalized angular frequency $\omega$ and $L_x$ and $C_x$.

***Mathematical model of the serially connected adjustable inductor***

For reactance statement $X(\omega)$ of a serially connected $L$ inductance;

$$X(\omega) = \omega L \qquad (1)$$

the formula above can be written. On the other hand, the admittance for $C_x // L_x$ parallel resonance circuit is as below;

$$Y_x(j\omega) = jB_x(\omega) = j\left[\omega C_x - \frac{1}{\omega L_x}\right] = j\left[\frac{\omega^2 L_x C_x - 1}{\omega L_x}\right] \qquad (2)$$

Elastance $B_x(\omega)$ is also shown as below;

$$B_x(\omega) = \frac{\omega^2 L_x C_x - 1}{\omega L_x} = \frac{\left(\frac{\omega}{\omega_r}\right)^2 - 1}{\omega L_x}$$

The angular resonance frequency $\omega_r$ in (2) is shown as follows;

$$\omega_r^2 = \frac{1}{L_x C_x} \qquad (3)$$

By using (2) and (3),

$$Z_x(j\omega) = jX_x(\omega) = \frac{1}{Y_x(j\omega)} = -j\frac{1}{B_x} \qquad (4)$$

or

$$X_x(\omega) = -\frac{1}{B_x} = \omega\frac{L_x}{1-\left(\frac{\omega}{\omega_r}\right)^2} = \omega L_t(\omega)$$

frequency-based adjustable inductor $L_t$ (FBAE) in (4) is given with

$$L_t(\omega) = \frac{L_x}{1-\left(\frac{\omega}{\omega_r}\right)^2} \qquad (5)$$

$L_x$ inductor is constant in formula (5). However, the resonance frequency $\omega_r$ changes when the value of the adjustable capacity changes. Beside this, the value of the adjustable inductor changes when the value of adjustable $C_x$ capacitor or similarly the angular frequency $\omega_r$ changes.

Now, $L_t$ adjustable inductor can be designed to be $X(\omega_0) = X_x(\omega_0)$ in $\omega = \omega_0$. Accordingly,

$$\omega_0 L = \omega_0 \frac{L_x}{1-\left(\frac{\omega_0}{\omega_r}\right)^2} \qquad (6)$$

is obtained. Hence, $L_x$ is shown as below for given $L$ inductor and selected angular frequency $\omega_0$ and resonance frequency $\omega_r$

$$L_x = \left[1-\left(\frac{\omega_0}{\omega_r}\right)^2\right] L > 0 \quad wherein; \ \omega_r > \omega_0 \qquad (7)$$

On this basis, when we use the formula (3), $C_x$ is given with

$$C_x = \frac{1}{\omega_r^2 L_x} \qquad (8)$$

The normalized angular frequency in aforesaid mathematical statements is selected as $\omega_0 = 1$ (constant) at the far end of the passband. For a verified inductor $L_x > 0$, resonance frequency $\omega_r$ should be greater than $\omega_0$. On the

other hand, it is known that serial equivalent impedance in $\omega_r$ is infinite. Starting from this point of view, $\omega_r$ should be selected away from $\omega_0$ on the band within reasons. The location of $\omega_r$ on the band depends on being verified of $C_x$ and $L_x$ practically.

For $L$ = 1, $\omega_0$ = 1 and $\omega_r$ = 2, the adjustable inductance is calculated as follows;

$$L_x = \left[1 - \left(\frac{\omega_0}{\omega_r}\right)^2\right] L = 0.75$$

By using the formula (8),

$$C_x = \frac{1}{\omega_r^2 L_x} = 0.3333$$

is found.

The frequency-based change graph of the inductive reactance for $0 \leq \omega \leq 1$ normalized angular frequency band is given in Figure 2.

We may define the error calculation as absolute value of the difference $X(\omega)$ and $X_x(\omega)$.

$$\varepsilon(\omega) = |X(\omega) - X_x(\omega)| \quad (9)$$

It is seen in Figure 2 that the absolute error in $0 \leq \omega \leq 1$ band range is smaller than 0,1.

The change graph of the frequency-based adjustable inductor $L_t = f(\omega, L_x, C_x)$ is given in Figure 3.

It may be seen in Figure 3 that frequency-based inductor remains in $L_x$ and $L$ range ($L_x \leq L_t(\omega) \leq L$).

Similarly, the value $L$ can be calculated for a constant $L_x$ and an angular frequency $\omega$, and at the same time the change of $L_t$ can be calculated as a function of the resonance frequency $\omega_r$ and the adjustable capacitor $C_x$. In case of $\omega = \omega_0 = 1$, the change of $L_t$ according to $\omega_r$ and $C_x$ is shown in Figure 4 and Figure 5, respectively.

As seen in Figure 5, the adjustability of the frequency-based inductor is quite narrow. If the value of the adjustable capacitor increases from $C_x$ = 0.1 to $C_x$ = 0.3, the **effective** value of $L_t$ increases from 0.8 to 0.95. This increase approximately corresponds to a %15 change.

### *The adjustable inductor that can be realized practically*

An adjustable capacitor $C_x$ can be realized by using a varactor diode in practice. The use graph of the varactor diode D as a capacitor is given in Figure 6. Accordingly, when the diode D is polarized at the passing direction ($V_D \geq 0$), it is ideally short-circuit position. When it is polarized at the blocking direction ($V_D < 0$), it would show a $C_D$ capacitance value depending on the value of polarization potential. The $C_D = f(V_D)$ change is given by the manufacturing company of the diode.

In this case, a frequency-based serial inductor whose value can be adjusted can be realized as in Figure 7.

Thus, in the case of inverse polarization of diode D, it would show a $\boldsymbol{C_D}$ capacity. In this case, $C_D$ capacity changing with inverse polarity potential and $C_0$ capacity whose value is constant would be an equivalent $C_x$ capacity. The value of $C_x$ capacity is given as follows.

$$C_x = \frac{C_D C_0}{C_D + C_0} \quad (10)$$

In this case, variable capacity $C_x$ would change between 0 and $C_0$ value ($0 \leq C_x \leq C_0$).

**Claims**

1. A frequency-based adjustable inductor (Lt) for use in communication systems **characterized in that** said inductor (Lt) comprises a voltage-adjustable capacitor ($C_x$) connected to a constant inductor ($L_x$) in parallel.

2. An adjustable inductor (Lt) according to claim 1, **characterized in that** said voltage-adjustable capacitor ($C_x$) is a varactor diode (D).

3. Use of the adjustable inductor (Lt) according to claim 1 or 2 in wireless communication systems.

4. The use according to claim 3 **characterized in that** said wireless communication system is suitable to at least one of the GSM-900MHz, GSM-1800MHz, 3G/4G, Wi-Fi and LTE/Wi-Max systems.

**Fig. 1**

**Fig. 2**

**Fig. 3**

Variation of $L_t$ with respect to $w_r$

**Fig. 4**

Variation of $L_t$ with respect to $C_x$

**Fig. 5**

**Fig. 6**

$L_x$ $L_x$ $L_x$

$L_t(\omega)$ D $C_0$ $C_D$ $C_0$ $C_x$

**Fig. 7**

**Europäisches Patentamt**
**European Patent Office**
**Office européen des brevets**

# EUROPEAN SEARCH REPORT

Application Number

EP 15 15 1849

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 504 443 B1 (EGUIZABAL ANTONIO L [US]) 7 January 2003 (2003-01-07) * column 1, line 64 - column 2, line 3; figures 2, 7 * * column 3, line 9 - line 40 * * column 4, line 9 - line 21 * ----- | 1-4 | INV. H03J3/18 |
| X | US 5 959 515 A (CORNETT KENNETH D [US] ET AL) 28 September 1999 (1999-09-28) * column 2, line 20 - line 49; figures 2,3 * ----- | 1-4 | |
| X | US 2006/055470 A1 (LUONG HOWARD C [HK] ET AL LUONG HOWARD CAM [HK] ET AL) 16 March 2006 (2006-03-16) * paragraph [0062]; claims 1, 2; figures 4, 8 * ----- | 1-4 | |
| X | US 2006/097811 A1 (NAKAMURA TAKAHIRO [JP] ET AL) 11 May 2006 (2006-05-11) * paragraphs [0002], [0068]; figures 2, 7 * ----- | 1-4 | TECHNICAL FIELDS SEARCHED (IPC) |
| A | US 2008/180194 A1 (LIU REN-CHIEH [TW] LIU REN CHIEH [TW]) 31 July 2008 (2008-07-31) * the whole document * ----- | 1-4 | H03J |

The present search report has been drawn up for all claims

| Place of search | Date of completion of the search | Examiner |
|---|---|---|
| The Hague | 3 June 2015 | Peeters, Mark |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 15 1849

This annex lists the patent family members relating to the patent documents cited in the above-mentioned European search report.
The members are as contained in the European Patent Office EDP file on
The European Patent Office is in no way liable for these particulars which are merely given for the purpose of information.

03-06-2015

| Patent document cited in search report | | Publication date | Patent family member(s) | | Publication date |
|---|---|---|---|---|---|
| US 6504443 | B1 | 07-01-2003 | NONE | | |
| US 5959515 | A | 28-09-1999 | NONE | | |
| US 2006055470 | A1 | 16-03-2006 | US | 2006055470 A1 | 16-03-2006 |
| | | | US | 2008042768 A1 | 21-02-2008 |
| US 2006097811 | A1 | 11-05-2006 | JP | 2006135829 A | 25-05-2006 |
| | | | US | 2006097811 A1 | 11-05-2006 |
| | | | US | 2011105053 A1 | 05-05-2011 |
| US 2008180194 | A1 | 31-07-2008 | TW | 200832888 A | 01-08-2008 |
| | | | US | 2008180194 A1 | 31-07-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20080180194 A1
- US 20040217882 A1